(19) Europäisches Patentamt / European Patent Office / Office européen des brevets

(11) **EP 2 410 346 B1**

(12) **FASCICULE DE BREVET EUROPEEN**

(45) Date de publication et mention
de la délivrance du brevet:
**12.07.2017 Bulletin 2017/28**

(51) Int Cl.:
***G01R 31/36*** (2006.01)

(21) Numéro de dépôt: **11174441.3**

(22) Date de dépôt: **19.07.2011**

(54) **Procédé de détermination d'un paramètre d'au moins un accumulateur d'une batterie**

Verfahren zur Bestimmung eines Parameter mindestens eines Akkus einer Batterie

Method of determining a parameter of at least one accumulator of a battery

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.07.2010 FR 1056036**

(43) Date de publication de la demande:
**25.01.2012 Bulletin 2012/04**

(73) Titulaires:
- **SAFT
93170 Bagnolet (FR)**
- **Institut National Polytechnique de Lorraine
54501 Vandoeuvre les Nancy (FR)**

(72) Inventeurs:
- **Desprez, Philippe
33200 Bordeaux (FR)**
- **Barrailh, Gérard
33170 Gradignan (FR)**
- **Zenati, Ali
33800 Bordeaux (FR)**
- **Rael, Stéphane
54000 Nancy (FR)**
- **Razik, Hubert
69330 Meyezieu (FR)**

(74) Mandataire: **Hirsch & Associés
137, rue de l'Université
75007 Paris (FR)**

(56) Documents cités:
**EP-A1- 1 632 782     FR-A1- 2 920 884
FR-A1- 2 941 054     US-A- 5 991 707**

**Description**

La présente invention se rapporte à un procédé de détermination d'un paramètre, tel que la résistance, l'état de charge ou la capacité, d'au moins un accumulateur d'une batterie, notamment afin de déterminer l'état de santé de la batterie ; ainsi qu'à un système électronique de supervision d'une batterie.

Typiquement une batterie comprend une pluralité d'accumulateurs appelés aussi générateurs électrochimiques, cellules ou éléments. Un accumulateur est un dispositif de production d'électricité dans lequel de l'énergie chimique est convertie en énergie électrique. L'énergie chimique est constituée par des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

Une batterie peut être divisée en modules, chaque module étant composé d'une pluralité d'accumulateurs reliés entre eux en série et/ou en parallèle. La batterie est destinée à fournir de l'énergie électrique à une application extérieure. Un circuit de charge est généralement prévu auquel la batterie peut être branchée pour recharger les accumulateurs. La batterie peut comporter une ou plusieurs branches parallèles d'accumulateurs reliés en série et/ou une ou plusieurs branches parallèles de modules reliés en série. Un système de gestion comprenant des capteurs de mesures et un circuit électronique de contrôle, plus ou moins évolué selon les applications, peut être associé à la batterie.

L'état de charge (SOC pour State of Charge en anglais) et l'état de santé (SOH pour State of Health en anglais) sont des informations utiles au système électronique de gestion de la batterie pour optimiser son utilisation et sa durée de vie.

Typiquement, l'état de charge SOC est déterminé comme la quantité d'énergie disponible dans la batterie, rapportée à l'énergie d'une batterie totalement chargée. L'état de charge SOC peut être calculé par exemple selon un algorithme utilisant des mesures de tension, ou l'intégration du courant de charge/décharge en fonction du temps selon les conditions de courant de la batterie.

L'état de santé SOH de la batterie permet d'estimer le vieillissement de la batterie entre un état neuf et un état fin de vie.

Une première méthode de détermination du SOH d'une batterie, dite statique, consiste à surveiller les valeurs de température, de tension, et éventuellement de courant de la batterie afin de déterminer une valeur de SOH à partir de lois de vieillissement. Ces lois de vieillissement sont obtenues à partir d'essais réalisés en laboratoire. Un algorithme de SOH donne alors une estimation du vieillissement de la batterie. Cependant ce mode de détermination du SOH de la batterie est soumis à l'hypothèse d'un vieillissement homogène des accumulateurs de la batterie. Le mode de détermination du SOH par un modèle prédictif suppose également un circuit de puissance sans défaillance entre les accumulateurs.

Une deuxième méthode de détermination du SOH d'une batterie, dite dynamique, consiste à calculer le rapport de la résistance de la batterie à un instant donné sur la résistance de la batterie à l'état neuf dans les mêmes conditions de mesure. Le SOH peut également être calculé à partir du rapport de la capacité de la batterie à un instant donné sur la capacité de la batterie à l'état neuf. Selon la taille de la batterie et/ou selon les applications, un calcul de SOH peut être fourni pour la batterie dans son ensemble ou pour chaque module ou pour chaque accumulateur.

Typiquement, la résistance d'une batterie (ou d'un accumulateur de la batterie) se mesure suivant une chute de tension sur deux points seulement, tout en considérant une incertitude relative liée à la mesure déterminée par une méthode classique de calcul d'incertitudes.

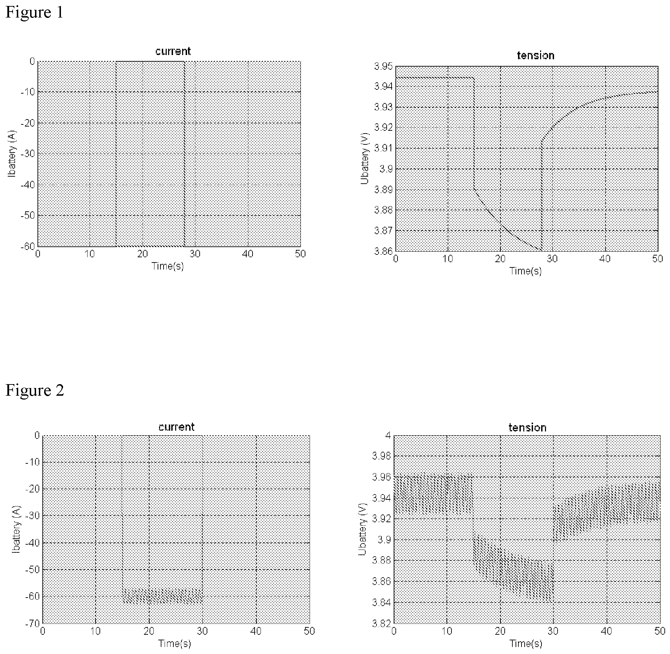

La figure 1 représente des signaux simulés idéaux de courant et de tension d'une batterie lors d'une impulsion de courant. Une détermination de la résistance peut être réalisée lors d'une telle impulsion : une première mesure de tension U1 est effectuée lorsque le courant est nul, la tension étant alors de 3,944 V ; et une seconde mesure de tension U2 est effectuée pendant l'impulsion avec un courant de -60 A, la tension étant de 3.864 V. On obtient alors une valeur de résistance R déterminée comme suit :

$$R = \Delta V / \Delta I = 1.33 \ m\Omega$$

Toutefois, en réalité, que l'impulsion soit provoquée lors d'un cycle de maintenance ou en application embarquée, les signaux idéaux représentés sur la figure 1 n'existent pas mais présentent des perturbations qui tiennent compte entre autres des incertitudes des capteurs de tensions et de courants. La figure 2 représente des signaux simulés bruités de courant et de tension d'une batterie lors d'une impulsion de courant. Typiquement, le capteur de courant présente une ondulation dans la partie basse de l'impulsion de 5% ; et le capteur de tension présente une ondulation liée à l'incertitude de 20 mV. Ainsi, avec une incertitude relative de 5% sur le courant et une incertitude absolue de 20 mV sur la tension, l'incertitude relative sur la mesure de
résistance se calcule comme suit en utilisant une méthode classique de calcul d'incertitudes :

$$dR/R = d\Delta V/\Delta V + d\Delta I/\Delta I = dU1/\Delta V + dU2/\Delta V + dI1/\Delta I + dI2/\Delta I,$$

soit une incertitude de 60%.

De même, si l'incertitude est calculée en utilisant la méthode des sommes quadratiques :

$$dR/R = \sqrt{(d\Delta V/\Delta V)^2 + (d\Delta I/\Delta I)^2},$$

on obtient une valeur d'incertitude de 51 %, ce qui reste loin d'une valeur fiable.

Par ailleurs, la mesure de résistance nécessite une impulsion de courant afin de provoquer une chute de tension permettant la mesure de deux couples de valeurs de tension et courant. A cet effet, la résistance de la batterie (ou d'un accumulateur de la batterie) est généralement mesurée lors d'une opération de maintenance ; par exemple lors d'un contrôle de la connexion de la batterie.

Lorsque la batterie est connectée à une application, il est possible d'estimer l'état de santé à l'aide de modèles prédictifs. Par exemple, le document FR-A-2 920 884 décrit un procédé d'estimation de l'état de santé d'une batterie embarquée dans un véhicule automobile. Ce procédé détecte un état stable de la batterie et génère un courant à ses bornes afin d'estimer la valeur de la résistance interne à partir des variations de courant et de tension. La valeur de la résistance interne est alors liée à une estimation de l'état de santé de la batterie au moyen d'une cartographie.

Le document WO-A-2007/004817 propose de déterminer la résistance interne de la batterie à partir de mesures de température et d'estimations de l'état de charge ; une résistance instantanée est mesurée à partir d'un couple de valeurs tension - courant, puis normalisée. La valeur de la résistance interne est alors liée à une estimation de l'état de santé de la batterie au moyen d'une table.

Le document US-A-2009/0140744 propose de déterminer une pseudo-impédance de la batterie à partir d'impulsions de décharge imposées à la batterie. L'état de santé de la batterie est alors déterminé à partir de cette pseudo-impédance.

Le document US-A-2009/0085517 décrit une méthode de gestion de la charge d'une batterie dans un portable qui utilise une méthode statistique pour comparer la valeur de la capacité restante à la valeur initiale.

Les méthodes connues pour déterminer la résistance d'une batterie (ou d'un accumulateur d'une batterie) utilisent des estimations et/ou des mesures directes assorties d'une importante incertitude. La détermination ultérieure de l'état de santé de la batterie s'en trouve fortement affectée.

EP-A-1 632 782 décrit une méthode de surveillance d'une batterie ainsi qu'un dispositif pour la mise en oeuvre de celle-ci. La méthode utilise deux charges test qui peuvent être connectées à la batterie et dans laquelle méthode, les états de décharge résultant de la connexion des charges tests à la batterie sont analysés afin de surveiller la résistance interne ou l'impédance de la batterie.

US 5 991 707 décrit une méthode et un système pour diagnostiquer des problèmes de fiabilité et/ou une panne dans un système physique grâce à l'identification prédictive de fluctuations erratiques d'un ou plusieurs paramètres de fonctionnement dudit système physique. Les valeurs d'au moins un type de paramètre de fonctionnement sont déterminées. Un flux de données des valeurs du paramètre sont divisées en un ou plusieurs ensembles, et les ensembles sont associés en une ou plusieurs séries. Grâce à une série de calculs mathématiques, on peut déterminer si un état N0, Nx ou N1 existe. Un état N0 indique que les valeurs sont probablement dans une plage de fonctionnement correcte. Une condition Nx indique la probabilité de rencontrer un point en dehors de la plage de fonctionnement correcte. Un état N1 indique l'entrée dans une plage correspondant à une panne possible du système.

Il existe donc un besoin pour une méthode de détermination de la résistance d'au moins un accumulateur d'une batterie qui présente une incertitude réduite et connue afin d'augmenter la confiance liée à la valeur de résistance et donc à la détermination ultérieure d'un état de santé. Il existe aussi un besoin pour une méthode de détermination de la résistance d'au moins un accumulateur d'une batterie qui puisse être indépendamment mise en oeuvre lorsque la batterie est en utilisation ou en maintenance.

Par ailleurs, comme indiqué plus haut, l'état de santé peut être déterminé à partir de la capacité d'au moins un accumulateur de la batterie.

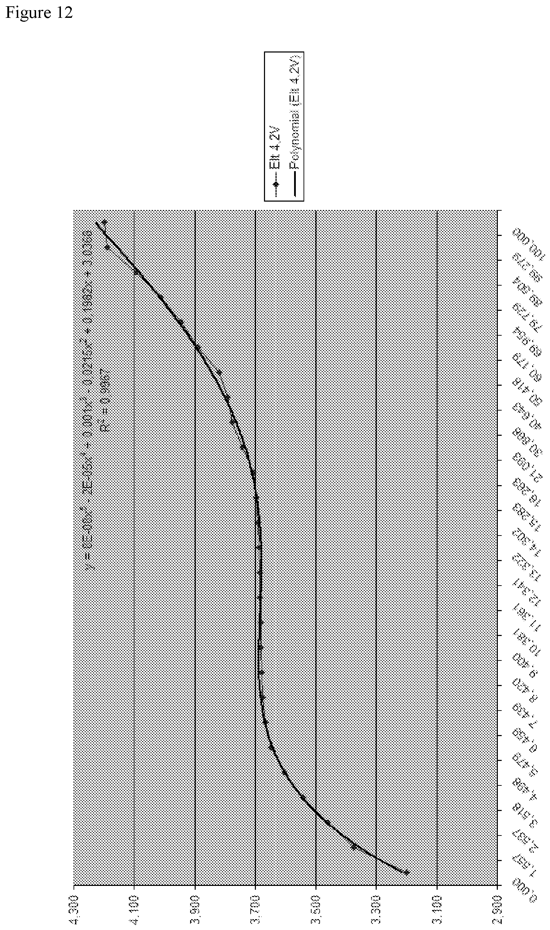

De manière connue en soi, la capacité d'un accumulateur peut être calculée à partir de valeurs d'état de charge à des instants différents, notamment pour des accumulateurs de type Li-Ion qui présentent une relation directe entre le SOC et la tension à vide. La figure 12 montre une telle courbe de l'état de charge en fonction de la tension à vide pour un accumulateur Li-Ion.

La capacité d'un accumulateur est exprimée en Ah par la relation suivante :

$$C = \frac{\int_{t_{initial}}^{t_{final}} Idt / 3600}{SOC(t_{final}) - SOC(t_{initial})}$$

La détermination des valeurs de SOC aux deux instants considérés (initial et final dans la formule ci-dessus) nécessite une mesure de courant et de tension à ces instants. Tout comme pour la détermination de la résistance, l'incertitude sur les mesures de courant et de tension entraîne une incertitude sur les valeurs de SOC et par conséquent sur la valeur de la capacité. Les méthodes connues pour déterminer la capacité d'une batterie (ou d'un accumulateur d'une batterie) utilisent des estimations et/ou des mesures directes assorties d'une importante incertitude. La détermination ultérieure de l'état de santé de la batterie s'en trouve fortement affectée.

Il existe donc aussi un besoin pour une méthode de détermination de la capacité d'au moins un accumulateur d'une batterie qui présente une incertitude réduite et connue afin d'augmenter la confiance liée à la valeur de capacité et donc à la détermination ultérieure d'un état de santé.

A cet effet, l'invention propose de déterminer la résistance ou la capacité d'au moins un accumulateur de la batterie à partir d'un calcul statistique qui fournit également la précision sur cette mesure. L'incertitude de mesure peut ainsi être considérablement réduite et la mesure finale peut être validée pour une détermination fiable de l'état de santé de la batterie.

Plus particulièrement, l'invention propose un procédé de détermination d'un paramètre d'au moins un accumulateur d'une batterie, le procédé comprenant les étapes consistant à :

- réaliser une série de mesures de tension et de courant aux bornes dudit au moins un accumulateur ;
- calculer une pluralité de valeurs du paramètre dépendant des mesures de tension et de courant ;
- déterminer une valeur du paramètre comme la moyenne des valeurs du paramètre calculées et un écart type associé ;
- déterminer une incertitude absolue de la valeur du paramètre comme le produit de l'écart type et d'un coefficient de Student lié au nombre de valeurs du paramètre calculées et à une probabilité choisie ;
- déterminer une incertitude relative de la valeur du paramètre ;
- si l'incertitude relative est inférieure ou égale à un seuil de précision prédéterminé, valider la valeur du paramètre.

Selon un premier mode de réalisation, le paramètre est une résistance d'au moins un accumulateur d'une batterie et le procédé comprend les étapes consistant à :

- mesurer un courant débité par ledit au moins un accumulateur ;
- mesurer une première tension aux bornes dudit au moins un accumulateur lorsque le courant est sensiblement égal à une valeur prédéterminée ;
- détecter une impulsion de courant ;
- réaliser la pluralité de mesures de tension et de courant dudit au moins un accumulateur pendant ladite impulsion ;
- calculer une pluralité de valeurs de résistance dudit au moins un accumulateur à partir de la première tension et de la pluralité de mesures de tension et de courant ;
- déterminer une valeur de résistance comme la moyenne des valeurs de résistance calculées et un écart type associé ;
- déterminer une incertitude absolue de la valeur de la résistance comme le produit de l'écart type et d'un coefficient de Student lié au nombre de valeurs de résistance calculées et à une probabilité choisie ;
- déterminer une incertitude relative de la valeur de la résistance ;
- si l'incertitude relative est inférieure ou égale à un seuil de précision prédéterminé, valider la valeur de résistance dudit au moins un accumulateur.

Selon un mode de réalisation, la détection d'une impulsion de courant comprend les étapes consistant à :

- déterminer un premier intervalle de temps entre une valeur de courant égale à la valeur prédéterminée et une valeur de courant d'impulsion ;
- déterminer un second intervalle de temps pendant lequel le courant correspond à un courant d'impulsion ;
- si le premier intervalle de temps est inférieur à un premier seuil et si le second intervalle de temps est supérieur à un deuxième seuil, effectuer les mesures de tension et de courant.

Selon un mode de réalisation, la détection d'une impulsion de courant comprend en outre l'étape consistant à déterminer si le courant d'impulsion demeure dans un intervalle de stabilité pendant le second intervalle de temps.

Selon un mode de réalisation, le premier seuil temporel, le deuxième seuil temporel et le seuil de courant sont ajustés en fonction de la température de la batterie.

Selon un mode de réalisation, la valeur prédéterminée du courant pour réaliser la première mesure de tension est sensiblement égale à zéro.

Selon un autre mode de réalisation, le paramètre est une valeur d'état de charge d'au moins un accumulateur d'une batterie et le procédé comprend les étapes consistant à :

- réaliser la pluralité de mesures de tension et de courant aux bornes dudit au moins un accumulateur lorsque le courant est sensiblement égal à une valeur prédéterminée ;
- calculer une pluralité de valeurs d'état de charge à partir de la pluralité de mesures de tension et de courant ;
- déterminer une valeur d'état de charge comme la moyenne de la pluralité de valeurs d'état de charge calculées et un écart type associé ;
- déterminer une incertitude absolue de la valeur d'état de charge comme le produit de l'écart type et d'un coefficient de Student lié au nombre de valeurs d'état de charge calculées et à une probabilité choisie ;
- déterminer une incertitude relative de la valeur d'état de charge ;
- si l'incertitude relative est inférieure ou égale à un seuil de précision prédéterminé, valider la valeur d'état de charge.

Selon un mode de réalisation, le procédé comprend en outre les étapes consistant à :

- déterminer une première valeur d'état de charge pour une première pluralité de mesures de tension et de courant aux bornes dudit au moins un accumulateur ;
- déterminer une deuxième valeur d'état de charge pour une deuxième pluralité de mesures de tension et de courant aux bornes dudit au moins un accumulateur ;
- calculer la capacité dudit au moins un accumulateur à partir des première et deuxième valeurs d'état de charge comme:

$$C = \frac{\int_{t1}^{t2} I dt / 3600}{SOC2 - SOC1}.$$

Selon un autre mode de réalisation, le paramètre est une valeur de capacité d'au moins un accumulateur d'une batterie et le procédé comprend les étapes consistant à :

- déterminer une première valeur d'état de charge dudit au moins un accumulateur ;
- réaliser la pluralité de mesures de tension et de courant aux bornes dudit au moins un accumulateur ;
- calculer une pluralité de deuxièmes valeurs d'état de charge à partir de la pluralité de mesures de tension et de courant ;
- calculer une pluralité de valeurs de capacité à partir des première et deuxième valeurs d'état de charge comme:

$$C_n = \frac{\int_{t1}^{t2} I dt / 3600}{SOC2_n - SOC1} ;$$

- déterminer une valeur de capacité comme la moyenne des valeurs de capacités calculées et un écart type associé ;
- déterminer une incertitude absolue de la valeur de la capacité comme le produit de l'écart type et d'un coefficient de Student lié au nombre de valeurs de capacité calculées et à une probabilité choisie ;
- déterminer une incertitude relative de la valeur de la capacité ;
- si l'incertitude relative est inférieure ou égale à un seuil de précision prédéterminé, valider la valeur de capacité dudit au moins un accumulateur.

Selon un mode de réalisation, la ou les deuxième valeurs d'état de charge sont utilisées pour calculer la capacité lorsqu'elles diffèrent d'au moins 10% de la première valeur d'état de charge.

Selon un mode de réalisation, le coefficient de Student est choisi pour une probabilité de 99,7%.

Selon un mode de réalisation, le seuil de précision est inférieur ou égal à 10%, par exemple le seuil de précision est de 5%.

Selon un mode de réalisation, la batterie comprend une pluralité d'accumulateurs reliés en série et/ou en parallèle et le paramètre est déterminé pour chaque accumulateur de la batterie, la pluralité de mesures de tension et de courant étant réalisée aux bornes de chaque accumulateur.

Selon un autre mode de réalisation, la batterie comprend une pluralité de modules reliés en série et/ou en parallèle, chaque module comprenant une pluralité d'accumulateurs, et le paramètre est déterminé pour chaque module de la batterie, la pluralité de mesures de tension et de courant étant réalisée aux bornes de chaque module.

Selon un autre mode de réalisation, le paramètre est déterminé pour la batterie, la pluralité de mesures de tension et de courant étant réalisée aux bornes de la batterie.

L'invention concerne aussi un procédé de détermination de l'état de santé d'au moins un accumulateur d'une batterie, comprenant les étapes consistant à :

- déterminer une valeur de résistance selon le procédé de l'invention ou une valeur de capacité selon le procédé de l'invention ;
- normaliser la valeur de résistance ou de capacité déterminée ;
- déterminer l'état de santé dudit au moins un accumulateur de la batterie comme le rapport de la résistance ou de la capacité déterminée normalisée sur la résistance ou la capacité dudit au moins un accumulateur à l'état neuf.

Selon un mode de réalisation, la résistance déterminée ou la capacité déterminée est normalisée à 25°C et à un courant correspondant au régime de décharge.

L'invention concerne encore un système de gestion électronique pour batterie comprenant :

- des moyens de mesure d'un courant débité par au moins un accumulateur de la batterie ;
- des moyens de mesure de la tension aux bornes dudit au moins un accumulateur ;
- un microprocesseur comprenant des moyens de programme pour effectuer les étapes du procédé de détermination d'un paramètre selon l'invention et/ou les étapes du procédé de détermination de l'état de santé selon l'invention.

L'invention concerne en outre une batterie comprenant une pluralité d'accumulateurs électrochimiques disposés en modules et/ou reliés en série et/ou en parallèle et au moins un système de gestion électronique selon l'invention.

D'autres caractéristiques et avantages de l'invention apparaîtront à la lecture de la description qui suit, donnée à titre d'exemple et en référence aux figures qui montrent :

- Figure 1, déjà décrite, des graphes de signaux simulés idéaux de courant et de tension d'une batterie lors d'une impulsion de courant ;
- Figure 2, déjà décrite, des graphes de signaux simulés bruités de courant et de tension d'une batterie lors d'une impulsion de courant ;
- Figure 3, un ordinogramme du procédé de détermination du SOH selon un premier mode de réalisation de l'invention;
- Figure 4, un ordinogramme de l'étape d'auto-détermination d'une impulsion dans le procédé selon le premier mode de réalisation de l'invention;
- Figure 5, des graphes montrant l'incertitude relative de la mesure de résistance et la mesure de résistance de la batterie lors d'une impulsion de courant ;
- Figure 6, des graphes montrant le courant de test appliqué à une batterie, le SOC, le courant de la batterie et la limite de précision imposée pour un test expérimental de la mise en oeuvre du procédé selon l'invention ;
- Figure 7, des graphes montrant les tensions aux bornes de chaque accumulateur de la batterie testée ;
- Figure 8, des graphes montrant les résistances mesurées aux bornes de chaque accumulateur de la batterie testée à chaque impulsion de courant quand la mesure est réalisée ;
- Figure 9, des graphes montrant les incertitudes relatives des mesures de résistances de la figure 7 ;
- Figure 10, des graphes montrant des agrandissements d'un cycle de test avec le courant débité d'un accumulateur, le coefficient de Student pour ledit accumulateur, la résistance mesurée dudit accumulateur et l'incertitude de ladite mesure ;
- Figure 11, une table des coefficients de Student pour différentes probabilités et différentes tailles d'échantillon ;
- Figure 12, déjà décrite, une courbe de l'état de charge en fonction de la tension à vide pour un accumulateur Li-Ion ;
- Figure 13, un ordinogramme du procédé de détermination du SOH selon un deuxième mode de réalisation de l'invention.

L'invention concerne un procédé de détermination d'un paramètre d'au moins un accumulateur d'une batterie avec une incertitude réduite et connue. La valeur du paramètre est déterminée de manière statistique sur une population de valeurs calculées à partir d'une pluralité de mesures de tension et courant.

L'invention concerne notamment un procédé de détermination de la résistance d'au moins un accumulateur d'une batterie comprenant une étude statistique pour le calcul de valeurs de résistances pendant une impulsion de courant. L'étude statistique permet de valider la valeur retenue de la résistance avec une grande confiance. Le procédé de l'invention comprend une étape d'auto-détection d'une impulsion de courant propice à l'étude statistique. Le procédé peut ainsi être mis en oeuvre lorsque la batterie est en utilisation ou en maintenance. A terme, le procédé de l'invention permet une estimation fiable de l'état de santé (SOH) de la batterie.

L'invention concerne aussi un procédé de détermination de la capacité d'au moins un accumulateur d'une batterie comprenant une étude statistique pour le calcul de valeurs de SOC à des instants différents. L'étude statistique permet de valider chaque valeur de SOC retenue avec une grande confiance. Le procédé peut être mis en oeuvre lorsque la batterie est en utilisation ou en maintenance. A terme, le procédé de l'invention permet une estimation fiable de l'état de santé (SOH) de la batterie

Le procédé selon l'invention peut être mis en oeuvre dans un système de gestion électronique pour batterie comprenant des moyens de mesure d'un courant débité par au moins un accumulateur de la batterie et des moyens de mesure de la tension aux bornes dudit au moins un accumulateur, ainsi qu'un microprocesseur comprenant des moyens de programme pour effectuer les étapes qui vont être décrites en détails ci-dessous.

La description qui suit est donnée pour un accumulateur d'une batterie. Il est cependant entendu que cette même description pourrait s'appliquer de manière similaire à un module d'une batterie, un tel module comprenant une pluralité d'accumulateurs reliés en série et/ou en parallèle de façon connue en soi ; le courant mesuré serait alors celui débité par le module et la tension mesurée serait celle mesurée aux bornes du module. De manière analogue, la même description pourrait s'appliquer à la batterie elle-même; le courant mesuré serait alors celui débité par la batterie et la tension mesurée serait celle mesurée aux bornes de la batterie. La décision de déterminer la résistance aux bornes de la batterie, de chaque module ou de chaque accumulateur dépend de l'application et du type de batterie. Le système de gestion électronique mettant en oeuvre le procédé selon l'invention peut également être reprogrammé au besoin si les capteurs de courant et de tension adéquats sont présents dans la batterie.

Premier mode de réalisation

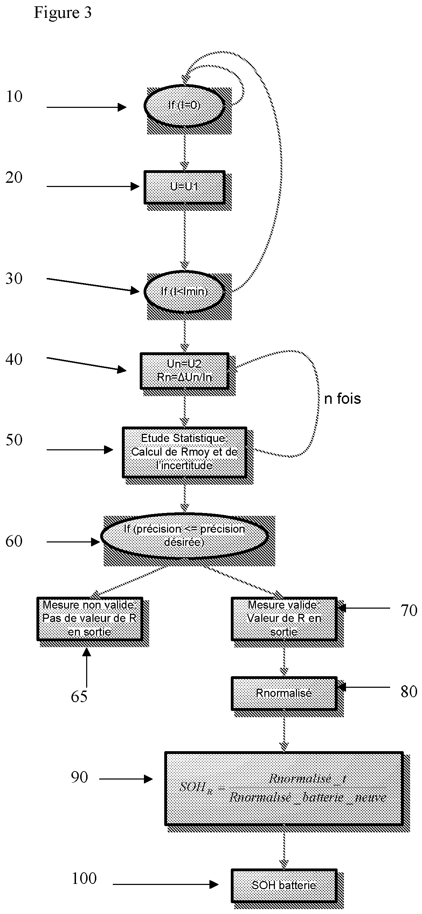

La figure 3 est un ordinogramme du procédé de détermination du SOH selon un premier mode de réalisation de l'invention, le SOH étant déterminé à partir de la résistance.

A l'étape 10, le courant (I) débité par l'accumulateur est mesuré. Si le courant est nul (I=0), la tension (U1) aux bornes de l'accumulateur est mesurée à l'étape 20. La tension U1 peut être soit une valeur unique soit une moyenne de valeurs mesurées pendant un laps de temps (1 à 2 secondes environ) lorsque le courant est nul, soit une étude statistique des valeurs mesurées utilisant par exemple une loi normale. Sinon, la mesure du courant se poursuit jusqu'à ce que le courant débité par l'accumulateur soit nul (boucle de l'étape 10).

Selon une variante de réalisation, à l'étape 10, on peut aussi mesurer la tension U1 pour un courant ayant une valeur prédéterminée I1 (au lieu de I=0). Les valeurs U1, I1 peuvent alors être un couple de valeurs uniques, un couple de moyennes de valeurs mesurées pendant un laps de temps lorsque le courant est sensiblement égal à I1, ou une étude statistique des valeurs mesurées utilisant par exemple une loi normale.

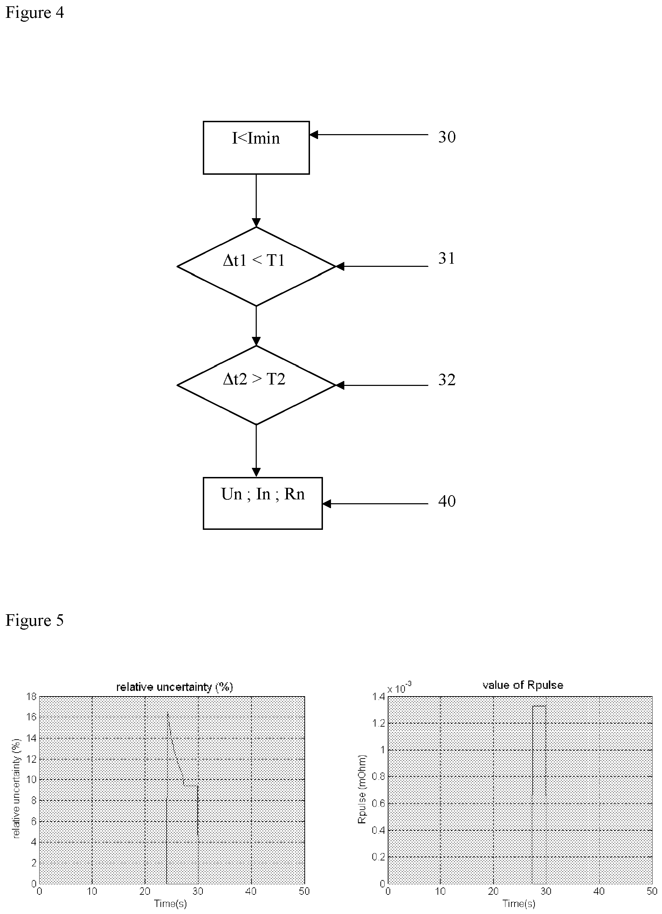

A l'étape 30, le procédé détecte une impulsion de courant (I < Imin qui correspond à une impulsion de décharge avec Imin<I1 ; mais on pourrait également considérer une impulsion de charge lorsque I>Imin avec Imin>I1). L'auto-détermination d'une impulsion sera décrite plus en détails en référence à l'ordinogramme de la figure 4.

A l'étape 40, une pluralité de mesures de tension et de courant (Un ; In) aux bornes de l'accumulateur sont effectuées pendant ladite impulsion, et une pluralité de valeurs de résistance de l'accumulateur (Rn = U1-Un / In) sont calculées. Chaque mesure est réalisée indépendamment des autres ; on obtient ainsi un échantillon de valeurs de résistances avec une distribution gaussienne de cet échantillon.

A l'étape 50, une étude statistique est conduite sur l'échantillon des valeurs de résistance calculées. Tout d'abord une valeur de résistance est déterminée, comme la moyenne des valeurs de résistance calculées. De manière connue en soi, une telle moyenne peut s'exprimer comme suit :

$$\overline{R} = \frac{1}{n}\sum_{i=1}^{n} R_i$$

A cette moyenne est associé un écart type (σ) caractérisant l'étalement de la distribution de l'échantillon des valeurs de résistance calculées. De manière connue en soi, l'écart type est la racine carrée de la variance qui peut s'exprimer comme suit :

$$s_m^2 = \frac{1}{n(n-1)} \sum_{i=1}^{n} (R_i - \overline{R})^2$$

A l'étape 60, la précision de la mesure est évaluée.

Une incertitude absolue de la valeur de la résistance ($\Delta R$) est tout d'abord déterminée comme le produit de l'écart type et d'un coefficient de Student ($t_{(vp)}$).

L'incertitude absolue est donc déterminée comme suit :

$$\Delta R = s_m t_{(vp)}$$

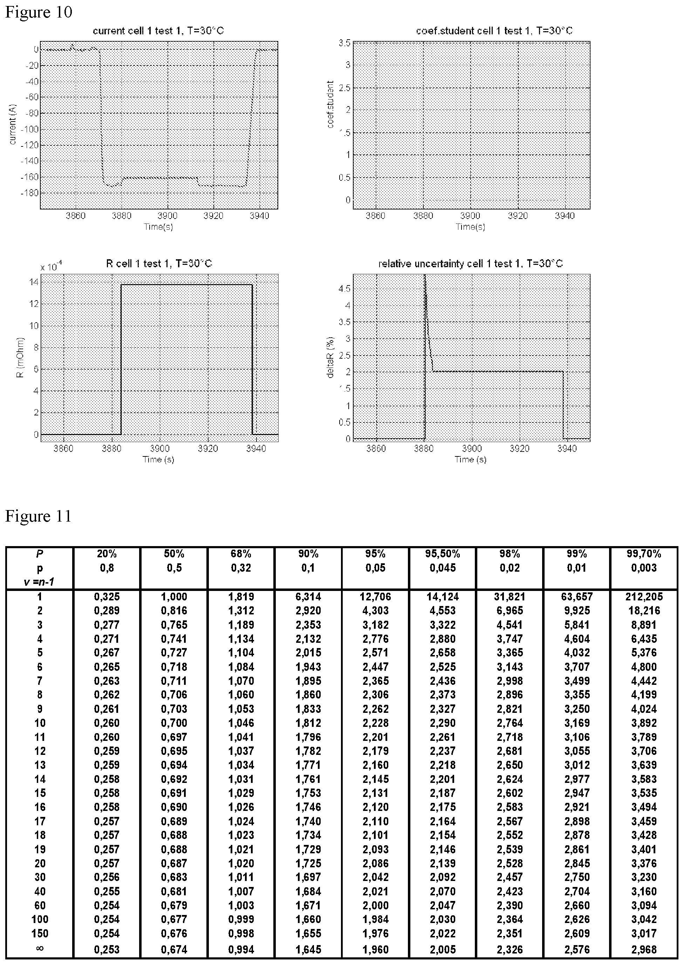

Le coefficient de Student permet de définir l'intervalle de confiance pour une probabilité donnée en fonction de la taille de l'échantillon. Par exemple, si l'on choisie une probabilité de $6\sigma$, c'est-à-dire que l'on tient compte de 99,7% des valeurs de l'échantillon, le coefficient de Student sera égal à 3.376 pour un échantillon des 20 valeurs. La figure 11 montre une table des coefficients de Student pour différentes probabilités et différentes tailles d'échantillon. Les valeurs reportées dans cette table sont connues en soi.

L'incertitude absolue $\Delta R$ dépend donc du nombre de mesures de résistance effectuées pendant l'impulsion ainsi que de la probabilité avec laquelle on veut connaître la vraie valeur dans l'intervalle des mesures. L'incertitude absolue dépend directement de l'étude statistique sur l'échantillon des valeurs de résistance calculées.

Il est alors possible de déterminer une incertitude relative comme suit : $\Delta R/R$

Si l'incertitude relative est inférieure ou égale à un seuil de précision prédéterminé ($\Delta R/R < S$), alors la valeur de résistance de l'accumulateur R peut être validée à l'étape 70. Le seuil de précision S peut être fixé bien en deçà de l'incertitude déterminée par la méthode classique de calcul d'incertitudes ou la méthode des écarts quadratiques. Par exemple, le seuil de précision peut être choisi inférieur à 10%, par exemple 5%.

La valeur de résistance R peut être fournie dès que l'incertitude relative est inférieure au seuil même si l'impulsion de courant se prolonge ; elle peut être ajustée, le cas échéant, au fur et à mesure du calcul statistique tant que dure l'impulsion ; la valeur de résistance peut aussi être fournie seulement après détection de la fin de l'impulsion, sous réserve que l'incertitude relative soit bien inférieure au seuil.

Si l'incertitude relative est supérieure au seuil fixé à la fin de l'impulsion ou après que le nombre d'échantillon est dépassé, la mesure de résistance de l'accumulateur R n'est pas validée (étape 65). Eventuellement, le système de gestion électronique mettant en oeuvre le procédé de l'invention peut inclure une routine d'alerte informant l'utilisateur qu'une mesure de résistance n'a pu être établie.

A l'étape 80, la valeur de résistance déterminée R est normalisée $R_{norm}$. On entend par résistance normalisée, la valeur de résistance qui aurait été déterminée à une température donnée, pour un courant donné et pour une durée d'impulsion donnée. Par exemple, la résistance est normalisée à 25°C, à un courant correspondant à un régime de décharge et pour une durée d'impulsion de 10 secondes. Une telle normalisation est effectuée en référence à des tables fournies par le fabricant et constituées lors de tests en laboratoire.

A l'étape 90, l'état de santé (SOH) de l'accumulateur est alors déterminé comme le rapport de la résistance normalisée $R_{norm}$ sur la résistance dudit accumulateur à l'état neuf à même température et à même courant. En général, les constructeurs fournissent avec chaque batterie et/ou chaque accumulateur vendu, une table attribuant une valeur de résistance en début de vie pour chaque couple température - courant.

A l'étape 100, une indication sur l'état de santé de la batterie est fournie. L'état de santé de la batterie est déterminé à partir de la résistance de la batterie qui peut être déterminé directement selon le procédé de l'invention par des mesures de tension et de courant (Un ; In) aux bornes de la batterie pendant ladite impulsion. La résistance de la batterie peut aussi être déterminée comme la moyenne des résistances déterminées de chaque module ou accumulateur constituant la batterie lorsque les mesures de tension et de courant (Un ; In) sont effectuées aux bornes de chaque module ou accumulateur pendant ladite impulsion.

Auto-détermination d'une impulsion

La figure 4 est un ordinogramme de l'auto-détermination d'une impulsion selon le procédé de l'invention.

A l'étape 30, une valeur de courant correspondant à une impulsion est détectée. L'impulsion peut être négative (en décharge) ou positive (en charge). Par exemple, une telle impulsion de courant peut être détectée pour I<Imin si Imin<I1 (impulsion de décharge) ou pour I>Imin si Imin>I1 (impulsion de charge). La figure 4 illustre le cas d'une impulsion en décharge (I < Imin).

Afin de permettre l'étude statistique conduisant à la détermination de la résistance de l'accumulateur, il convient de disposer d'un échantillon suffisant de valeurs de résistance mesurées. A cet effet, l'impulsion doit présenter des critères temporels permettant aux mesures (Un ; In ; Rn) de l'étape 40 précédemment décrite de composer un échantillon exploitable.

A l'étape 31, un premier intervalle de temps ($\Delta t1$) est déterminé entre une valeur de courant nul (I=0) et une valeur de courant inférieur au seuil prédéterminé (I < Imin). Si ce premier intervalle de temps est inférieur à un premier seuil ($\Delta t1$ < T1), alors la pente de variation est suffisamment importante pour présenter les caractéristiques d'une impulsion et notamment une chute de tension suffisante pour permettre un calcul de résistance.

A l'étape 32, un second intervalle de temps ($\Delta t2$) est déterminé pendant lequel le courant reste inférieur audit seuil (I < Imin). Si ce second intervalle de temps est supérieur à un deuxième seuil ($\Delta t2$ > T2), alors la largeur de l'impulsion est suffisante pour permettre la constitution d'un échantillon de taille exploitable, en étant à courant stable, par exemple une variation $\Delta I$ de +/- 20% autour de I. Notamment, si l'impulsion est trop courte, l'échantillon sera de petite taille et le coefficient de Student sera élevé, conduisant à une forte incertitude absolue et probablement à l'invalidation de la résistance déterminée par le procédé de l'invention.

Le premier seuil temporel (T1), le deuxième seuil temporel (T2) ainsi que le seuil de courant (Imin) peuvent être prédéterminés ou ajustés en fonction de la température de la batterie. Le système de gestion électronique mettant en oeuvre le procédé de l'invention peut être programmé avec des seuils fixes ou variables dépendant de la température selon les applications. Les seuils temporels (T1, T2) peuvent également dépendre du pas de mesure des capteurs de tension et courant. Une reprogrammation du système est en outre possible.

Si ces deux critères temporels sont remplis, le procédé reconnaît une impulsion exploitable pour la détermination d'une valeur de résistance, que la batterie soit en utilisation ou en maintenance. Une mesure de résistance peut ainsi être effectuée, avec une grande fiabilité, tout au long de l'utilisation de la batterie. L'état de santé de la batterie peut alors être déterminé régulièrement avec une grande fiabilité.

La figure 5 illustre l'incertitude relative et la mesure de résistance fournies par le procédé de l'invention lors d'une impulsion de courant telle que celle illustrée sur la figure 2.

On remarque que la mesure a débuté environ 10 secondes après le début de l'impulsion ; le seuil T2 ayant alors été atteint. On remarque également que les premières mesures de résistance présentent une forte incertitude, la taille de l'échantillon statistique étant encore faible ; puis l'incertitude descend sous le seuil de 10% autorisant la validation d'une valeur de résistance R de 1.33 m$\Omega$. Ainsi, la mesure avec signal bruité réalisée grâce à l'invention donne bien, la même valeur de R que la mesure réalisée pour un signal idéal sans bruit, tout en garantissant une incertitude sur la mesure inférieure à 10%.

Exemple de mise en oeuvre du premier mode de réalisation

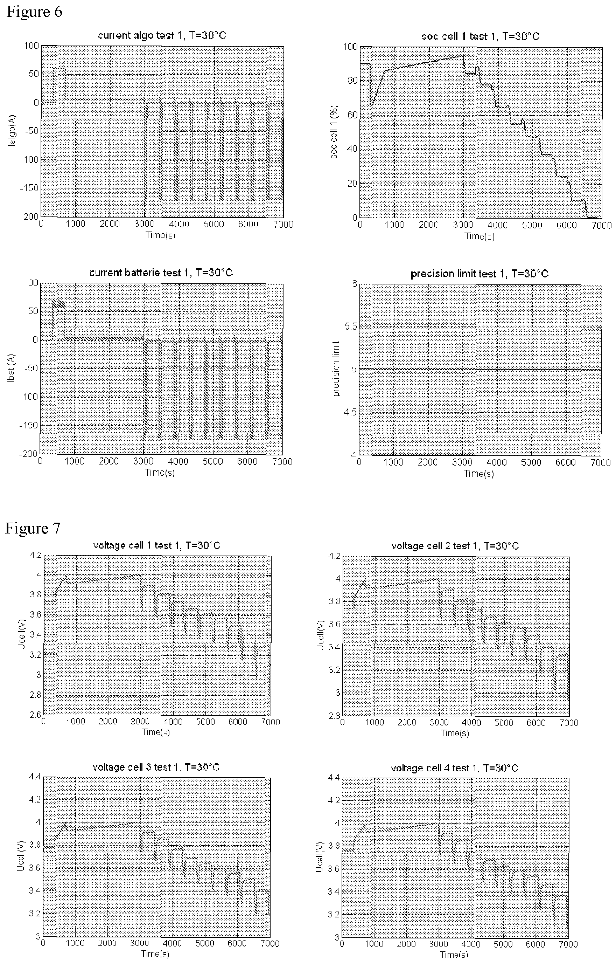

Les figures 6 à 10 illustrent un exemple de mise en oeuvre du procédé selon l'invention sur une batterie comprenant quatre accumulateurs de type VL30P en série. Deux accumulateurs étaient vieillis et deux accumulateurs étaient à l'état neuf pour le test. Les accumulateurs ont été placés dans une enceinte climatique et une première série de tests a été conduite à 30°C et une seconde série de tests a été conduite à 0°C. Chaque série de test comportait deux tests. Un premier test imposait un courant d'impulsion non idéal avec un niveau bas de 170A tous les 10% d'état de charge en considérant des accumulateurs avec un SOC de 100% en début de test ; puis après recharge des accumulateurs, un deuxième test imposait un courant d'impulsion non idéal avec un niveau bas de 70A tous les 10% d'état de charge. L'acquisition des données a été faite toutes les 100 ms et le seuil d'incertitude relative S a été imposé à 5%.

Les figures 6 à 10 ne présentent que le premier test de la première série (30°C et 170A). La figure 6 montre ainsi le courant de test appliqué, l'état de charge de l'accumulateur 1, le courant débité par la batterie et le seuil de précision imposé. La figure 7 montre les tensions aux bornes de chacun des accumulateurs testés.

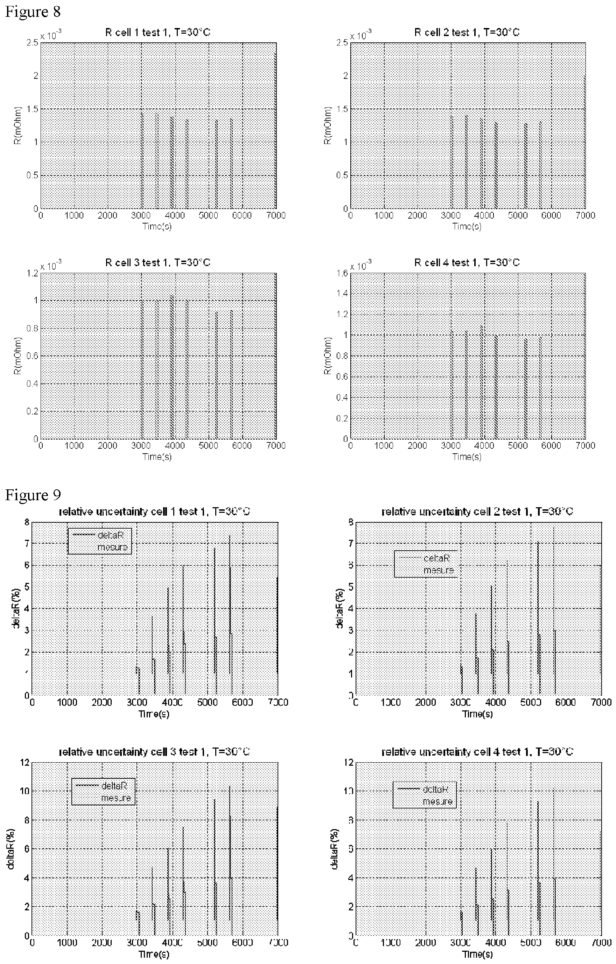

Les figures 8 et 9 montrent les résistances et incertitudes déterminées selon le procédé de l'invention pour chaque accumulateur de la batterie.

On remarque que certaines impulsions de courant n'ont pas donné lieu à une détermination de résistance, soit que les critères temporels ($\Delta t1$ < T1 ; $\Delta t2$ > T2) de détection d'une impulsion n'aient pas été vérifiés, soit que le courant est hors intervalle de stabilité ($\Delta I$).

La figure 10 est une vue agrandie sur une impulsion de test de la figure 6. On remarque que la mesure de résistance de l'accumulateur R est fournie avec une incertitude de 2%, soit bien inférieur au seuil fixé de 5%. Dans cet exemple, la valeur de résistance n'est fournie qu'après un temps donné, même si la précision était déjà atteinte. On remarque aussi que l'incertitude relative chute fortement lorsque le coefficient de Student diminue, c'est-à-dire lorsque la taille de l'échantillon de mesures augmente ; c'est donc bien le calcul statistique qui permet de fournir une valeur de résistance fiable.

Le deuxième test (courant d'impulsion non idéal avec un niveau bas de 70A tous les 10% d'état de charge) a permis de valider les seuils de détection d'une impulsion (T1, T2, Imin).

La deuxième série de test (à 0°C) a permis de valider la méthode de calcul statistique sur une large plage de température et d'affiner les seuils de détection d'une impulsion (T1, T2, Imin), la température influant notamment sur la pente de l'impulsion de courant.

Les tests réalisés montrent que la valeur de résistance déterminée selon le procédé de l'invention présente une incertitude relative nettement améliorée par rapport aux méthodes de l'état de la technique. Une détermination plus fiable du SOH et donc une meilleure gestion de la batterie sont ainsi possibles.

Deuxième mode de réalisation

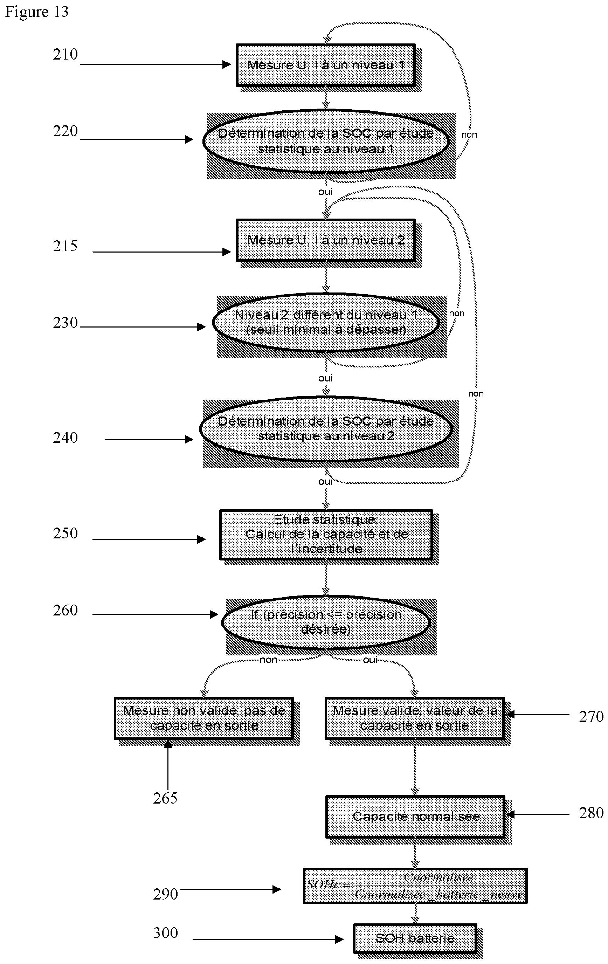

La figure 13 est un ordinogramme du procédé de détermination du SOH selon un deuxième mode de réalisation de l'invention, le SOH étant déterminé à partir de la capacité.

A l'étape 210, une première pluralité de mesures de tension et de courant (Un ; In) aux bornes de l'accumulateur est effectuée lorsque le courant est sensiblement égal à une valeur prédéterminée. Cette première pluralité de mesures est désignée mesure de niveau 1.

A l'étape 220, une valeur d'état de charge de niveau 1 est déterminée selon la méthode statistique de l'invention. Cette méthode a été décrite en détail en référence au calcul statistique d'une valeur de résistance. Elle s'applique de manière analogue au calcul d'une valeur de SOC à deux niveaux de charge différents afin de déterminer une valeur de capacité avec une incertitude limitée et connue.

Une pluralité de valeurs d'état de charge SOC de l'accumulateur sont calculées à partir des mesures de tension et courant de niveau 1. Chaque valeur de SOC est calculée à partir d'un couple tension - courant mesuré en se reportant à la caractérisation de l'accumulateur mesuré (figure 12).

Notamment, si le courant de niveau 1 est sensiblement nul, une valeur mesurée de tension Un correspondra à la tension à vide $U_0$ de l'accumulateur et la valeur de SOC se lira directement sur la courbe de caractérisation. Si le courant de niveau 1 n'est pas nul, une valeur équivalente de tension à vide $U_0$ sera déterminée par $U_0=Un - RIn$ afin de calculer la valeur de SOC.

Chaque mesure de tension et de courant (Un, In) étant réalisée indépendamment des autres, on peut calculer une pluralité de valeurs d'état de charge SOC indépendantes les unes des autres ; on obtient ainsi un échantillon de valeurs de SOC de niveau 1 avec une distribution gaussienne de cet échantillon.

Le SOC de niveau 1 peut être soit une valeur unique, soit une moyenne de valeurs mesurées, soit une étude statistique.

Le SOC de niveau 1 déterminé selon une étude statistique pourra être calculé comme suit.

Une valeur SOC1 est déterminée comme la moyenne des valeurs de SOC de niveau 1 calculées. De manière connue en soi, une telle moyenne peut s'exprimer comme suit :

$$\overline{SOC1} = \frac{1}{n}\sum_{i=1}^{n} SOC1_i$$

A cette moyenne est associé un écart type ($\sigma$) caractérisant l'étalement de la distribution de l'échantillon des valeurs de SOC calculées au niveau 1. De manière connue en soi, l'écart type est la racine carrée de la variance qui peut s'exprimer comme suit :

$$s_m^2 = \frac{1}{n(n-1)}\sum_{i=1}^{n} (SOC1_i - \overline{SOC1})^2$$

Une incertitude absolue de la valeur d'état de charge de niveau 1 ($\Delta SOC1$) peut alors être déterminée comme le produit de l'écart type et d'un coefficient de Student ($t_{(vp)}$), de manière similaire à ce qui a déjà été décrit en référence au calcul statistique de la résistance. Une incertitude relative est alors déterminée comme $\Delta SOC1/SOC1$. L'incertitude absolue sur le SOC n'est calculée que si l'offset sur les mesures de tension est sensiblement nul. En effet, une telle étude statistique du SOC ne permettrait pas d'éliminer une erreur systématique du capteur de mesure de tension. Le système de gestion électronique mettant en oeuvre l'invention peut inclure des composants de calibration permettant de garantir un offset sensiblement nul sur les mesures de tension.

Si cette incertitude relative est inférieure ou égale à un seuil de précision prédéterminé, alors la valeur de d'état de charge de niveau 1 de l'accumulateur SOC1 peut être validée (passage à l'étape 215). Le seuil de précision peut être fixé bien en deçà de l'incertitude déterminée par la méthode classique de calcul d'incertitudes ou la méthode des écarts quadratiques. Par exemple, le seuil de précision peut être choisi inférieur à 10%, par exemple 5%.

Une valeur de SOC peut être fournie dès que l'incertitude relative est inférieure au seuil. Selon une alternative, le calcul statistique peut se poursuivre sur une durée donnée et la valeur de SOC peut être ajustée, le cas échéant, au fur et à mesure du calcul statistique.

Si l'incertitude relative est supérieure au seuil fixé à la fin d'une durée de mesure donnée ou après que le nombre d'échantillon est dépassé, la mesure de SOC de l'accumulateur n'est pas validée (retour à l'étape 210).

A l'étape 215, une deuxième pluralité de mesures de tension et de courant (Un ; In) aux bornes de l'accumulateur est effectuée. Cette deuxième pluralité de mesures est désignée mesure de niveau 2. Le courant des mesures de niveau 2 peut avoir une valeur prédéterminée nulle ou non nulle, égale à la valeur prédéterminée des mesures de niveau 1 ou différente.

A l'étape 230, il est vérifié que les conditions de niveau 2 sont suffisamment distinctes des conditions de niveau 1 pour permettre une exploitation des valeurs de SOC pour calculer une capacité. On vérifie par exemple qu'une ou quelques premières mesures de couples tension - courant au niveau 2 fournissent une première valeur de SOC de niveau 2 différente d'au moins 10% de la valeur SOC1 de niveau 1 déjà validée. Si les conditions de niveau 2 sont trop proches des conditions de niveau 1, la capacité pourra être entachée d'une erreur systématique que le calcul statistique ne peut éluder. L'étape 215 est alors répétée jusqu'à ce que des conditions acceptables soient réunies pour effectuer une détermination de SOC à un niveau 2 et donc de la capacité.

A l'étape 240, une valeur d'état de charge de niveau 2 est déterminée selon la méthode statistique de l'invention. L'étape 240 est en tout point similaire à l'étape 220 et une description détaillée n'en sera pas répétée. Notamment, une valeur SOC2 est déterminée comme la moyenne des valeurs de SOC de niveau 2 calculées à partir des couples tension - courant mesurés au niveau 2 ; une incertitude absolue $\Delta$SOC2 est déterminée comme le produit de l'écart type sur l'échantillon de niveau 2 et d'un coefficient de Student ; puis une incertitude relative est déterminée $\Delta$SOC2/SOC2. Si cette incertitude relative est inférieure ou égale à un seuil de précision prédéterminé, alors la valeur de d'état de charge de niveau 2 de l'accumulateur SOC2 peut être validée.

A l'étape 250, une valeur de capacité peut être calculée à partir des deux valeurs de SOC déterminées et validées selon la méthode statistique de l'invention. Plus précisément, la capacité peut être calculée selon la relation :

$$C = \frac{\int_{t1}^{t2} Idt / 3600}{SOC2 - SOC1}$$

avec SOC1 et SOC2 les valeurs d'état de charge de l'accumulateur déterminées et validées aux étapes 220 et 240.

Si la valeur de SOC au niveau 1 est une valeur unique ou une simple moyenne de valeurs mesurées, la valeur de SOC de niveau 2 sera obligatoirement issue d'une étude statistique telle que décrit ci-dessus.

A l'étape 260, la précision de la valeur de capacité ainsi déterminée est estimée. Un seuil de précision est attaché à chacune des valeurs de SOC ; on peut alors connaître le seuil de précision de la valeur de capacité en appliquant le pire cas ou un écart quadratique aux seuils de précision des SOC. Si le seuil de précision fixé pour la valeur de capacité est respecté, la mesure de capacité de l'accumulateur est validée (étape 270). Si le seuil de précision fixée pour la valeur de capacité est dépassé, la mesure de capacité de l'accumulateur n'est pas validée (étape 265). L'ensemble des étapes 210 à 260 peut être répété. Eventuellement, le système de gestion électronique mettant en oeuvre le procédé de l'invention peut inclure une routine d'alerte informant l'utilisateur qu'une mesure de capacité n'a pu être établie si la validation est refusée consécutivement à plusieurs reprises.

A l'étape 280, la valeur de capacité déterminée C est normalisée $C_{norm}$. On entend par capacité normalisée, la valeur de capacité qui aurait été déterminée à une température donnée et pour un courant donné. Par exemple, la capacité est normalisée à 25°C, à un courant correspondant à un régime de décharge C. Une telle normalisation est effectuée en référence à des tables fournies par le fabricant et constituées lors de tests en laboratoire.

A l'étape 290, l'état de santé (SOH) de l'accumulateur est alors déterminé comme le rapport de la capacité normalisée $C_{norm}$ sur la capacité dudit accumulateur à l'état neuf à même température et à même courant. En général, les constructeurs fournissent avec chaque batterie et/ou chaque accumulateur vendu, une table attribuant une valeur de capacité en début de vie pour chaque couple température - courant.

A l'étape 200, une indication sur l'état de santé de la batterie est fournie. L'état de santé de la batterie est déterminé à partir de la capacité de la batterie qui peut être déterminé directement selon le procédé de l'invention par des mesures de tension et de courant (Un ; In) aux bornes de la batterie à deux niveaux de charge différents. La capacité de la batterie peut aussi être déterminée comme la moyenne ou le minimum des capacités déterminées de chaque module ou accumulateur constituant la batterie lorsque les mesures de tension et de courant (Uni ; In) sont effectuées aux bornes de chaque module ou accumulateur à des niveaux 1 et 2 de charge différents.

Variante du deuxième mode de réalisation

On pourrait également, à partir d'une valeur de SOC de niveau 1 unique et d'une pluralité de valeurs de SOC de niveau 2 calculées à partir des couples tension - courant mesurés au niveau 2, calculer directement une capacité par étude statistique.

En effet, chaque valeur de SOC2 calculée à partir d'un couple tension - courant mesuré au niveau 2, peut être utilisée pour déterminer une valeur de capacité

$$C_i = \frac{\int_{t1}^{t2} Idt \, / \, 3600}{SOC2_i - SOC1}$$

On calcule alors une capacité moyenne par :

$$\overline{C} = \frac{1}{n} \sum_{i=1}^{n} C_i$$

A cette moyenne est associé un écart type ($\sigma$) caractérisant l'étalement de la distribution de l'échantillon des valeurs de capacités calculées. De manière connue en soit, l'écart type est la racine carrée de la variance qui peut s'exprimer comme suit :

$$s_m^2 = \frac{1}{n(n-1)} \sum_{i=1}^{n} (C_i - \overline{C})^2$$

Une incertitude absolue de la valeur de la capacité ($\Delta C$) peut alors être déterminée comme le produit de l'écart type et d'un coefficient de Student ($t_{(vp)}$), de manière similaire à ce qui a déjà été décrit en référence au calcul statistique de la résistance ou du SOC. Une incertitude relative est alors déterminée comme $\Delta C/C$. Cette incertitude est indépendante de l'offset de tension du fait de la différence entre deux mesures de SOC.

Les premier et deuxième modes de réalisation peuvent être combinés. Notamment, le système électronique de gestion de la batterie peut mettre en oeuvre un procédé de détermination de la résistance tel que décrit en référence à la figure 3 et utiliser cette valeur de résistance ainsi déterminée lorsqu'il détermine une valeur de SOC pour une tension à courant non nul. Le système électronique de gestion de la batterie peut également déterminer l'état de santé SOH par une détermination statistique de la résistance et, parallèlement ou alternativement, par une détermination statistique de la capacité.

Bien entendu, la présente invention n'est pas limitée aux modes de réalisation précédemment décrits à titre d'exemple. Les tests présentés pour valider le procédé de mesure de la résistance et de détermination du SOH n'ont été fournis qu'à titre d'exemple. Le procédé selon l'invention est notamment applicable à des batteries constituées de n'importe quel type d'accumulateurs électrochimiques sans limitation au Lithium Ion, Lithium polymère, alcalin, supercapacité et supercapacité hybride. En outre, le nombre d'accumulateurs reliés en série et/ou en parallèle peut varier sans que cela modifie substantiellement la mise en oeuvre du procédé selon l'invention. De même, les exemples numériques donnés concernant les valeurs de seuils (S, Imin, T1, T2...) peuvent être modifiés selon les applications.

**Revendications**

1. Procédé de détermination d'un paramètre d'au moins un accumulateur d'une batterie, le procédé comprenant les étapes consistant à :

   - réaliser une série de mesures de tension et de courant (Un ; In) aux bornes dudit au moins un accumulateur ;
   - calculer une pluralité de valeurs du paramètre dépendant des mesures de tension et de courant (Un ; In) ;
   - déterminer une valeur du paramètre comme la moyenne des valeurs du paramètre calculées et un écart type associé ;
   - déterminer une incertitude absolue de la valeur du paramètre comme le produit de l'écart type et d'un coefficient de Student lié au nombre de valeurs du paramètre calculées et à une probabilité choisie ;
- déterminer une incertitude relative de la valeur du paramètre ;
- si l'incertitude relative est inférieure ou égale à un seuil de précision prédéterminé, valider la valeur du paramètre.

**2.** Procédé de détermination d'un paramètre selon la revendication 1, dans lequel ledit paramètre est une résistance d'au moins un accumulateur d'une batterie, le procédé comprenant les étapes consistant à :

- mesurer un courant (I) débité par ledit au moins un accumulateur ;
- mesurer une première tension (U1) aux bornes dudit au moins un accumulateur lorsque le courant est sensiblement égal à une valeur prédéterminée (I=I1) ;
- détecter une impulsion de courant ;
- réaliser la pluralité de mesures de tension et de courant (Un ; In) dudit au moins un accumulateur pendant ladite impulsion ;
- calculer une pluralité de valeurs de résistance dudit au moins un accumulateur à partir de la première tension et de la pluralité de mesures de tension et de courant (Rn=|U1-Un|/|I1-In|);
- déterminer une valeur de résistance (R) comme la moyenne des valeurs de résistance calculées

$( \overline{R} = \frac{1}{n} \sum_{i=1}^{n} R_i )$ et un écart type ($s_m$) associé ;

- déterminer une incertitude absolue de la valeur de la résistance ($\Delta$R) comme le produit de l'écart type et d'un coefficient de Student ($t_{(vp)}$) lié au nombre de valeurs de résistance calculées et à une probabilité choisie ($\Delta$R=$s_m$ $t_{(vp)}$) ;
- déterminer une incertitude relative de la valeur de la résistance ($\Delta$R/R) ;
- si l'incertitude relative est inférieure ou égale à un seuil de précision prédéterminé ($\Delta$R/R < S), valider la valeur de résistance (R) dudit au moins un accumulateur.

**3.** Procédé de détermination d'un paramètre selon la revendication 2, dans lequel la détection d'une impulsion de courant comprend les étapes consistant à :

- déterminer un premier intervalle de temps ($\Delta$t1) entre une valeur de courant égale à la valeur prédéterminée et une valeur de courant d'impulsion ;
- déterminer un second intervalle de temps ($\Delta$t2) pendant lequel le courant correspond à un courant d'impulsion ;
- si le premier intervalle de temps est inférieur à un premier seuil ($\Delta$t1 < T1) et si le second intervalle de temps est supérieur à un deuxième seuil ($\Delta$t2 > T2), effectuer les mesures de tension et de courant (Un ; In).

**4.** Procédé de détermination d'un paramètre selon la revendication 3, dans lequel la détection d'une impulsion de courant comprend en outre l'étape consistant à déterminer si le courant d'impulsion demeure dans un intervalle de stabilité ($\Delta$I) pendant le second intervalle de temps ($\Delta$t2).

**5.** Procédé de détermination d'un paramètre selon la revendication 3 ou 4, dans lequel le premier seuil temporel (T1), le deuxième seuil temporel (T2) et le seuil de courant (Imin) sont ajustés en fonction de la température de la batterie.

**6.** Procédé de détermination de la résistance selon l'une des revendications 2 à 5, dans lequel la valeur prédéterminée (1=11) du courant pour réaliser la première mesure de tension (U1) est sensiblement égale à zéro.

**7.** Procédé de détermination d'un paramètre selon la revendication 1, dans lequel ledit paramètre est une valeur d'état de charge d'au moins un accumulateur d'une batterie, le procédé comprenant les étapes consistant à :

- réaliser la pluralité de mesures de tension et de courant (Un ; In) aux bornes dudit au moins un accumulateur lorsque le courant est sensiblement égal à une valeur prédéterminée (I=I1) ;
- calculer une pluralité de valeurs d'état de charge (SOCn) à partir de la pluralité de mesures de tension et de courant (Un ; In);
- déterminer une valeur d'état de charge (SOC) comme la moyenne de la pluralité de valeurs d'état de charge

calculées ( $\overline{SOC} = \frac{1}{n} \sum_{i=1}^{n} SOC_i$ ) et un écart type ($s_m$) associé ;

- déterminer une incertitude absolue de la valeur d'état de charge (ΔSOC) comme le produit de l'écart type et d'un coefficient de Student ($t_{(vp)}$) lié au nombre de valeurs d'état de charge calculées et à une probabilité choisie ($\Delta SOC = s_m\, t_{(vp)}$);
- déterminer une incertitude relative de la valeur d'état de charge (ΔSOC/SOC);
- si l'incertitude relative est inférieure ou égale à un seuil de précision prédéterminé (ΔSOC/SOC < S), valider la valeur d'état de charge (SOC).

**8.** Procédé de détermination d'un paramètre selon la revendication 7, comprenant en outre les étapes consistant à :

- déterminer une première valeur d'état de charge (SOC1) pour une première pluralité de mesures de tension et de courant (U1n ; I1n) aux bornes dudit au moins un accumulateur ;
- déterminer une deuxième valeur d'état de charge (SOC2) pour une deuxième pluralité de mesures de tension et de courant (U2n ; I2n) aux bornes dudit au moins un accumulateur ;
- calculer la capacité dudit au moins un accumulateur à partir des première et deuxième valeurs d'état de charge comme :

$$C = \frac{\int_{t1}^{t2} I\,dt\,/\,3600}{SOC2 - SOC1}.$$

**9.** Procédé de détermination d'un paramètre selon la revendication 1, dans lequel ledit paramètre est une valeur de capacité d'au moins un accumulateur d'une batterie, le procédé comprenant les étapes consistant à :

- déterminer une première valeur d'état de charge (SOC1) dudit au moins un accumulateur ;
- réaliser la pluralité de mesures de tension et de courant (Un ; In) aux bornes dudit au moins un accumulateur ;
- calculer une pluralité de deuxième valeurs d'état de charge (SOC2n) à partir de la pluralité de mesures de tension et de courant (Un ; In);
- calculer une pluralité de valeurs de capacité à partir des première et deuxième valeurs d'état de charge comme :

$$C_n = \frac{\int_{t1}^{t2} I\,dt\,/\,3600}{SOC2_n - SOC1}\; ;$$

- déterminer une valeur de capacité (C) comme la moyenne des valeurs de capacités calculées ($\overline{C} = \dfrac{1}{n}\sum_{i=1}^{n} C_i$) et un écart type ($s_m$) associé ;
- déterminer une incertitude absolue de la valeur de la capacité (ΔC) comme le produit de l'écart type et d'un coefficient de Student ($t_{(vp)}$) lié au nombre de valeurs de capacité calculées et à une probabilité choisie ($\Delta C = s_m\, t_{(vp)}$) ;
- déterminer une incertitude relative de la valeur de la capacité (ΔC/C) ;
- si l'incertitude relative est inférieure ou égale à un seuil de précision prédéterminé (ΔC/C < S), valider la valeur de capacité (C) dudit au moins un accumulateur.

**10.** Procédé de détermination d'un paramètre selon la revendication 8 ou 9, dans lequel la ou les deuxième valeurs d'état de charge (SOC2) sont utilisées pour calculer la capacité (C) lorsqu'elles diffèrent d'au moins 10% de la première valeur d'état de charge (SOC1).

**11.** Procédé de détermination d'un paramètre selon l'une quelconque des revendications précédentes, dans lequel le coefficient de Student est choisi pour une probabilité de 99,7%.

**12.** Procédé de détermination d'un paramètre selon l'une quelconque des revendications précédentes, dans lequel le seuil de précision (S) est inférieur ou égal à 10%.

EP 2 410 346 B1

**13.** Procédé de détermination d'un paramètre selon l'une quelconque des revendications précédentes, dans lequel le seuil de précision (S) est de 5%.

**14.** Procédé de détermination d'un paramètre selon l'une quelconque des revendications 1 à 13, dans lequel la batterie comprend une pluralité d'accumulateurs reliés en série et/ou en parallèle et dans lequel le paramètre est déterminé pour chaque accumulateur de la batterie, la pluralité de mesures de tension et de courant (Un; In) étant réalisée aux bornes de chaque accumulateur.

**15.** Procédé de détermination d'un paramètre selon l'une quelconque des revendications 1 à 13, dans lequel la batterie comprend une pluralité de modules reliés en série et/ou en parallèle, chaque module comprenant une pluralité d'accumulateurs, et dans lequel le paramètre est déterminé pour chaque module de la batterie, la pluralité de mesures de tension et de courant (Un ; In) étant réalisée aux bornes de chaque module.

**16.** Procédé de détermination d'un paramètre selon l'une quelconque des revendications 1 à 13, dans lequel le paramètre est déterminé pour la batterie, la pluralité de mesures de tension et de courant (Un ; In) étant réalisée aux bornes de la batterie.

**17.** Procédé de détermination de l'état de santé (SOH) d'au moins un accumulateur d'une batterie, comprenant les étapes consistant à :

- déterminer une valeur de résistance (R) selon l'une quelconque des revendications 2 à 6 ou de capacité (C) selon l'une quelconque des revendications 8 à 10 ;
- normaliser la valeur de résistance ou de capacité déterminée ;
- déterminer l'état de santé (SOH) dudit au moins un accumulateur de la batterie comme le rapport de la résistance ou de la capacité déterminée normalisée sur la résistance ou la capacité dudit au moins un accumulateur à l'état neuf.

**18.** Procédé de détermination de l'état de santé (SOH) selon la revendication 17, dans lequel la résistance déterminée (R) ou la capacité déterminée (C) est normalisée à 25°C et à un courant correspondant au régime de décharge.

**19.** Système de gestion électronique pour batterie comprenant :

- des moyens de mesure d'un courant débité par au moins un accumulateur de la batterie ;
- des moyens de mesure de la tension aux bornes dudit au moins un accumulateur ;
- un microprocesseur comprenant des moyens de programme pour effectuer les étapes de l'une quelconque des revendications 1 à 18.

**20.** Batterie comprenant une pluralité d'accumulateurs électrochimiques disposés en modules et/ou reliés en série et/ou en parallèle et au moins un système de gestion électronique selon la revendication 19.

**Patentansprüche**

**1.** Verfahren zur Bestimmung eines Parameters mindestens eines Akkus einer Batterie, wobei das Verfahren die folgenden Schritte umfasst, die darin bestehen:

- eine Reihe von Spannungs- und Strommessungen (Un; In) an den Klemmen des mindestens einen Akkus durchzuführen;
- eine Vielzahl von Werten des Parameters in Abhängigkeit von den Spannungs- und Strommessungen (Un; In) zu berechnen;
- einen Wert des Parameters als Durchschnitt der berechneten Werte des Parameters und eine zugeordnete Standardabweichung zu bestimmen;
- eine absolute Unsicherheit des Werts des Parameters als das Produkt der Standardabweichung und eines Student-Koeffizienten, in Verbindung mit der Anzahl von berechneten Werten des Parameters und einer gewählten Wahrscheinlichkeit zu bestimmen;
- eine relative Unsicherheit des Werts des Parameters zu bestimmen;
- wenn die relative Unsicherheit kleiner oder gleich einer vorbestimmten Genauigkeitsschwelle ist, den Wert des Parameters zu bestimmen.

**2.** Verfahren zur Bestimmung eines Parameters nach Anspruch 1, bei dem der Parameter ein Widerstand mindestens eines Akkus einer Batterie ist, wobei das Verfahren die folgenden Schritte umfasst, die darin bestehen:

- einen, von dem mindestens einen Akku abgegebenen Strom (I) zu messen;
- eine erste Spannung (U1) an den Klemmen des mindestens einen Akkus zu messen, wenn der Strom im Wesentlichen gleich einem vorbestimmten Wert (I=I1) ist;
- einen Stromimpuls zu erfassen;
- eine Vielzahl von Spannungs- und Strommessungen (Un; In) des mindestens einen Akkus während des Impulses durchzuführen;
- eine Vielzahl von Widerstandswerten des mindestens einen Akkus auf Basis der ersten Spannung und der Vielzahl von Spannungs- und Strommessungen (Rn=|U1-Un|/|I1-In|) zu berechnen;
- einen Widerstandswert (R) als den Durchschnitt der berechneten Widerstandswerte $\left( \overline{R} = \frac{1}{n} \sum_{i=1}^{n} R_i \right)$ und eine zugeordnete Standardabweichung ($s_m$) zu bestimmen;
- eine absolute Unsicherheit des Werts des Widerstandes (ΔR) als das Produkt der Standardabweichung und eines Student-Koeffizienten ($t_{(vp)}$) in Verbindung mit der Anzahl von berechneten Widerstandswerten und einer gewählten Wahrscheinlichkeit (ΔR=$s_m t_{(vp)}$) zu bestimmen;
- eine relative Unsicherheit des Werts des Widerstandes (ΔR/R) zu bestimmen;
- wenn die relative Unsicherheit kleiner oder gleich einer vorbestimmten Genauigkeitsschwelle (ΔR/R<S) ist, den Widerstandswert (R) des mindestens einen Akkus zu validieren.

**3.** Verfahren zur Bestimmung eines Parameters nach Anspruch 2, bei dem die Erfassung eines Stromimpulses die folgenden Schritte umfasst, die darin bestehen:

- ein erstes Zeitintervall (Δt1) zwischen einem Stromwert gleich dem vorbestimmten Wert und einem Impulsstromwert zu bestimmen;
- ein zweites Zeitintervall (Δt2) zu bestimmen, währenddessen der Strom einem Impulsstrom entspricht;
- wenn das erste Zeitintervall kleiner als ein erster Schwellenwert (Δt1 < T1) ist, wenn das zweite Zeitintervall größer als ein zweiter Schwellenwert (Δt2 > T2) ist, die Spannungs- und Strommessungen (Un; In) durchzuführen.

**4.** Verfahren zur Bestimmung eines Parameters nach Anspruch 3, bei dem die Erfassung eines Stromimpulses ferner den Schritt umfasst, der darin besteht zu bestimmen, ob der Stromimpuls während des zweiten Zeitintervalls (Δt2) in einem Stabilitätsintervall (ΔI) bleibt.

**5.** Verfahren zur Bestimmung eines Parameters nach Anspruch 3 oder 4, bei dem die erste Zeitschwelle (T1), die zweite Zeitschwelle (T2) und der Schwellwertstrom (Imin) in Abhängigkeit von der Temperatur der Batterie angepasst werden.

**6.** Verfahren zur Bestimmung des Widerstandes nach einem der Ansprüche 2 bis 5, bei dem der vorbestimmte Wert (I=I1) des Stroms für die Durchführung der ersten Spannungsmessung (U1) im Wesentlichen gleich Null ist.

**7.** Verfahren zur Bestimmung eines Parameters nach Anspruch 1, bei dem der Parameter ein Wert eines Ladezustands mindestens eines Akkus einer Batterie ist, wobei das Verfahren die folgenden Schritte umfasst, die darin bestehen:

- eine Vielzahl von Spannungs- und Strommessungen (Un; In) an den Klemmen des mindestens einen Akkus durchzuführen, wenn der Strom im Wesentlichen gleich einem vorbestimmten Wert (I=I1) ist;
- eine Vielzahl von Ladezustandswerten (SOCn) aus der Vielzahl von Spannungs- und Strommessungen (Un; In) zu berechnen;
- einen Ladezustandswert (SOC) als den Durchschnitt der Vielzahl von berechneten Ladezustandswerten $\left( \overline{SOC} = \frac{1}{n} \sum_{i=1}^{n} SOC_i \right)$ und eine zugeordnete Standardabweichung ($s_m$) zu bestimmen;
- eine absolute Unsicherheit des Ladezustandswerts (ΔSOC) als das Produkt der Standardabweichung und eines Student-Koeffizienten ($t_{(vp)}$), in Verbindung mit der Anzahl von berechneten Ladezustandswerten und einer gewählten Wahrscheinlichkeit (ΔXOC=$s_m t_{(vp)}$) zu bestimmen;

- eine relative Unsicherheit des Ladezustandswerts (∆SOC/SOC) zu bestimmen;
- wenn die relative Unsicherheit kleiner oder gleich einer vorbestimmten Genauigkeitsschwelle (∆SOC/SOC<S) ist, den Ladezustandswert (SOC) zu validieren.

**8.** Verfahren zur Bestimmung eines Parameters nach Anspruch 7, ferner umfassend die folgenden Schritte, die darin bestehen:

- einen ersten Wert eines Ladezustands (SOC1) für eine erste Vielzahl von Spannungs- und Strommessungen (U1n; I1n) an den Klemmen des mindestens einen Akkus zu bestimmen;
- einen zweiten Wert eines Ladezustands (SOC2) für eine zweite Vielzahl von Spannungs- und Strommessungen (U2n; I2n) an den Klemmen des mindestens einen Akkus zu bestimmen;
- die Kapazität des mindestens einen Akkus aus den ersten und zweiten Ladezustandswerten zu berechnen als:

$$C = \frac{\int_{t1}^{t2} I dt / 3600}{SOC2 - SOC1}.$$

**9.** Verfahren zur Bestimmung eines Parameters nach Anspruch 1, bei dem der Parameter ein Kapazitätswert mindestens eines Akkus einer Batterie ist, wobei das Verfahren die folgenden Schritte umfasst, die darin bestehen:

- einen ersten Wert eines Ladezustands (SOC1) des mindestens einen Akkus zu bestimmen;
- eine Vielzahl von Spannungs- und Strommessungen (Un; In) an den Klemmen des mindestens einen Akkus durchzuführen;
- eine Vielzahl von zweiten Werten eines Ladezustands (SOC2n) aus der Vielzahl von Spannungs- und Strommessungen (Un; In) zu berechnen;
- eine Vielzahl von Kapazitätswerten aus den ersten und zweiten Ladezustandswerten zu berechnen als:

$$C_n = \frac{\int_{t1}^{t2} I dt / 3600}{SOC2_n - SOC1};$$

- einen Kapazitätswert (C) als den Durchschnitt der berechneten Kapazitätswerte $\left( \overline{C} = \frac{1}{n} \sum_{i=1}^{n} C_i \right)$ und eine zugeordnete Standardabweichung ($s_m$) zu bestimmen;
- eine absolute Unsicherheit des Werts der Kapazität (∆C) als das Produkt der Standardabweichung und eines Student-Koeffizienten ($t_{(vp)}$) in Verbindung mit der Anzahl von berechneten Kapazitätswerten und einer gewählten Wahrscheinlichkeit (∆C=$s_m t_{(vp)}$) zu bestimmen;
- eine relative Unsicherheit des Werts der Kapazität (∆C/C) zu bestimmen;
- wenn die relative Unsicherheit kleiner oder gleich einer vorbestimmten Genauigkeitsschwelle (∆C/C<S) ist, den Kapazitätswert (C) des mindestens einen Akkus zu validieren.

**10.** Verfahren zur Bestimmung eines Parameters nach Anspruch 8 oder 9, bei dem der oder die zweiten Ladzustandswerte (SOC2) verwendet werden, um die Kapazität (C) zu berechnen, wenn sie um mindestens 10% vom ersten Ladezustandswert (SOC1) abweichen.

**11.** Verfahren zur Bestimmung eines Parameters nach einem jeden der vorhergehenden Ansprüche, bei dem der Student-Koeffizient für eine Wahrscheinlichkeit von 99,7% gewählt wird.

**12.** Verfahren zur Bestimmung eines Parameters nach einem jeden der vorhergehenden Ansprüche, bei dem die Genauigkeitsschwelle (S) kleiner oder gleich 10% ist.

17

**13.** Verfahren zur Bestimmung eines Parameters nach einem jeden der vorhergehenden Ansprüche, bei dem die Genauigkeitsschwelle (S) 5% ist.

**14.** Verfahren zur Bestimmung eines Parameters nach einem jeden der Ansprüche 1 bis 13, bei dem die Batterie eine Vielzahl von in Reihe und/oder parallel geschalteten Akkus umfasst und bei dem der Parameter für jeden Akku der Batterie bestimmt wird, wobei die Vielzahl von Spannungs- und Strommessungen (Un; In) an den Klemmen jedes Akkus erfolgt.

**15.** Verfahren zur Bestimmung eines Parameters nach einem jeden der Ansprüche 1 bis 13, bei dem die Batterie eine Vielzahl von in Reihe und/oder parallel geschalteten Modulen umfasst, wobei jedes Modul eine Vielzahl von Akkus umfasst, und bei dem der Parameter für jedes Modul der Batterie bestimmt wird, wobei die Vielzahl von Spannungs- und Strommessungen (Un; In) an den Klemmen jedes Moduls erfolgt.

**16.** Verfahren zur Bestimmung eines Parameters nach einem jeden der Ansprüche 1 bis 13, bei dem der Parameter für die Batterie bestimmt wird, wobei die Vielzahl von Spannungs- und Strommessungen (Un; In) an den Klemmen der Batterie erfolgt.

**17.** Verfahren zur Bestimmung des Zustands (SOH) mindestens eines Akkus einer Batterie, das die folgenden Schritte umfasst, die darin bestehen:

- einen Widerstandswert (R) nach einem jeden der Ansprüche 2 bis 6 oder einen Kapazitätswert (C) nach einem jeden der Ansprüche 8 bis 10 zu bestimmen;
- den bestimmten Widerstands- oder Kapazitätswert zu normieren;
- den Zustand (SOH) des mindestens einen Akkus der Batterie als das Verhältnis des bestimmten normierten Widerstands oder der bestimmten normierten Kapazität zu dem Widerstand oder der Kapazität des mindestens einen Akkus im Neuzustand zu bestimmen.

**18.** Verfahren zur Bestimmung des Zustands (SOH) nach Anspruch 17, bei dem der bestimmte Widerstand (R) oder die bestimmte Kapazität (C) bei 25°C und einem der Entladerate entsprechenden Strom normiert wird.

**19.** Elektronisches Verwaltungssystem für eine Batterie, die Folgendes umfasst:

- Mittel zum Messen eines, von mindestens einem Akku der Batterie abgegebenen Stroms;
- Mittel zum Messen der Spannung an den Klemmen des mindestens einen Akkus;
- einen Mikroprozessor, der Programmmittel umfasst, um die Schritte nach einem jeden der Ansprüche 1 bis 18 durchzuführen.

**20.** Batterie, die eine Vielzahl von elektrochemischen Akkus, die in Modulen angeordnet und/oder in Reihe und/oder parallel geschaltet sind und mindestens ein elektronisches Verwaltungssystem nach Anspruch 19 umfasst.

**Claims**

**1.** A method for determining a parameter of at least one secondary cell of a battery, the method comprising the steps of:

- conducting a series of voltage and current measurements (Un; In) at the terminals of said at least one secondary cell;
- calculating a plurality of values of the parameter depending on the voltage and current measurements (Un; In);
- determining a value of the parameter as the average of the calculated values of the parameter and an associated standard deviation;
- determining an absolute uncertainty on the value of the parameter as the product of the standard deviation and of a Student's coefficient related to the number of calculated values of the parameter and to a selected probability;
- determining a relative uncertainty on the value of the parameter;
- if the relative uncertainty is less than or equal to a predetermined accuracy threshold, validating the value of the parameter.

**2.** The method for determining a parameter according to claim 1, wherein said parameter is a resistance of at least one secondary cell of a battery, the method comprising the steps:

- measuring a current (I) delivered by said at least one secondary cell;
- measuring a first voltage (U1) at the terminals of said at least one secondary cell when the current is substantially equal to a predetermined value (I=I1);
- detecting a current pulse;
- conducting the plurality of voltage and current measurements (Un; In) of said at least one secondary cell during said pulse;
- calculating a plurality of resistance values of said at least one secondary cell from the first voltage and from the plurality of voltage and current measurements (Rn=|U1-Un|/|I1-In|);

- determining a resistance value (R) as the average of the calculated resistance values $( \overline{R} = \frac{1}{n} \sum_{i=1}^{n} R_i )$ and an associated standard deviation ($s_m$);

- determining an absolute uncertainty on the value of the resistance ($\Delta R$) as the product of the standard deviation and of a Student's coefficient ($t_{(vp)}$) related to the number of calculated resistance values and to a selected probability ($\Delta R = s_m t_{(vp)}$);
- determining a relative uncertainty on the value of the resistance ($\Delta R/R$);
- if the relative uncertainty is less than or equal to a predetermined accuracy threshold ($\Delta R/R < S$), validating the resistance value (R) of said at least one secondary cell.

3. The method for determining a parameter according to claim 2, wherein the detection of a current pulse comprises the steps:

- determining a first time interval ($\Delta t1$) between a current value equal to the predetermined value and a pulse current value;
- determining a second time interval ($\Delta t2$) during which the current corresponds to a pulse current;
- if the first time interval is less than a first threshold ($\Delta t1 < T1$) and if the second time interval is greater than a second threshold ($\Delta t2 > T2$), carrying out the voltage and current measurements (Un; In).

4. The method for determining a parameter according to claim 3, wherein the detection of a current pulse further comprises the step of determining whether the pulse current remains in a stability interval ($\Delta I$) during the second time interval ($\Delta t2$).

5. The method for determining a parameter according to claim 3 or 4, wherein the first time threshold (T1), the second time threshold (T2) and the current threshold (Imin) are adjusted according to the temperature of the battery.

6. The method for determining the resistance according to any of claims 2 to 5, wherein the predetermined value (I=I1) of the current for conducting the first voltage measurement (U1) is substantially equal to zero.

7. The method for determining a parameter according to claim 1, wherein said parameter is a stage-of-charge value of at least one secondary cell of a battery, the method comprising the steps:

- conducting the plurality of voltage and current measurements (Un; In) at the terminals of said at least one secondary cell when the current is substantially equal to a predetermined value (I=I1);
- calculating a plurality of state-of charge values (SOCn) from the plurality of voltage and current measurements (Un; In);
- determining a state-of-charge value (SOC) as the average of the plurality of calculated state-of-charge values

$( \overline{SOC} = \frac{1}{n} \sum_{i=1}^{n} SOC_i )$ and an associated standard deviation ($s_m$);

- determining an absolute uncertainty on the state-of-charge value ($\Delta SOC$) as the product of the standard deviation and of a Student's coefficient ($t_{(vp)}$) related to the number of calculated state-of-charge values and to a selected probability ($\Delta SOC = s_m t_{(vp)}$);
- determining a relative uncertainty on the state-of-charge value ($\Delta SOC/SOC$);
- if the relative uncertainty is less than or equal to a predetermined accuracy threshold ($\Delta SOC/SOC < S$), validating the state-of-charge value (SOC).

8. The method for determining a parameter according to claim 7, further comprising the steps:

  - determining a first state-of-charge value (SOC1) for a first plurality of voltage and current measurements (U1n; I1n) at the terminals of said at least one secondary cell;
  - determining a second state-of-charge value (SOC2) for a second plurality of voltage and current measurements (U2n; I2n) at the terminals of said at least one secondary cell;
  - calculating the capacity of said at least one secondary cell from the first and second state-of-charge values as:

$$C = \frac{\int_{t1}^{t2} Idt / 3600}{SOC2 - SOC1}.$$

9. The method for determining a parameter according to claim 1, wherein said parameter is a capacity value of at least one secondary cell of a battery, the method comprising the steps:

  - determining a first state-of-charge value (SOC1) of said at least one secondary cell;
  - conducting the plurality of voltage and current measurements (Un; In) at the terminals of said at least one secondary cell;
  - calculating a plurality of second state-of-charge values (SOC2n) from the plurality of voltage and current measurements (Un; In);
  - calculating a plurality of capacity values from the first and second state-of-charge values as:

$$C_n = \frac{\int_{t1}^{t2} Idt / 3600}{SOC2_n - SOC1};$$

  - determining a capacity value (C) as the average of the calculated capacity values ($\overline{C} = \frac{1}{n}\sum_{i=1}^{n} C_i$) and an associated standard deviation ($s_m$);
  - determining an absolute uncertainty on the value of the capacity ($\Delta C$) as the product of the standard deviation and of a Student's coefficient ($t_{(vp)}$) related to the number of calculated capacity values and to a selected probability ($\Delta C = s_m t_{(vp)}$);
  - determining a relative uncertainty on the value of the capacity ($\Delta C/C$);
  - if the relative uncertainty is less than or equal to a predetermined accuracy threshold ($\Delta C/C < S$), validating the capacity value (C) of said at least one secondary cell.

10. The method for determining a parameter according to claim 8 or 9, wherein the second state-of-charge value(s) (SOC2) is(are) used for calculating the capacity (C) when they differ by at least 10% from the first state-of-charge value (SOC1).

11. The method for determining a parameter according to any of the preceding claims, wherein the Student's coefficient is selected for a probability of 99.7%.

12. The method for determining a parameter according to any of the preceding claims, wherein the accuracy threshold (S) is less than or equal to 10%.

13. The method for determining a parameter according to any of the preceding claims, wherein the accuracy threshold (S) is 5%.

14. The method for determining a parameter according to any of claims 1 to 13, wherein the battery comprises a plurality of secondary cells connected in series and/or in parallel and wherein the parameter is determined for each secondary cell of the battery, the plurality of voltage and current measurements (Un; In) being conducted at the terminals of each secondary cell.

15. The method for determining a parameter according to any of claims 1 to 13, wherein the battery comprises a plurality of modules connected in series and/or in parallel, each module comprising a plurality of secondary cells, and wherein the parameter is determined for each module of the battery, the plurality of voltage and current measurements (Un; In) being conducted at the terminals of each module.

16. The method for determining a parameter according to any of claims 1 to 13, wherein the parameter is determined for the battery, the plurality of voltage and current measurements (Un; In) being conducted at the terminals of the battery.

17. A method for determining the state of health (SOH) of at least one secondary cell of a battery, comprising the steps:

- determining a resistance value (R) according to any of claims 2 to 6 or capacity (C) according to any of claims 8 to 10;
- normalizing the determined resistance or capacity value;
- determining the state of health (SOH) of said at least one secondary cell of the battery as the ratio of the normalized determined resistance or capacity over the resistance or capacity of said at least one secondary cell in the brand-new condition.

18. The method for determining the state of health (SOH) according to claim 17, wherein the determined resistance (R) or the determined capacity (C) is normalized at 25°C and at a current corresponding to discharge conditions.

19. An electronic management system for a battery comprising:

- means for measuring a current delivered by at least one secondary cell of the battery;
- means for measuring the voltage at the terminals of said at least one secondary cell;
- a microprocessor comprising program means for carrying out the steps of any of claims 1 to 18.

20. A battery comprising a plurality of electrochemical secondary cells arranged in modules and/or connected in series and/or in parallel and at least one electronic management system according to claim 19.

Figure 1

Figure 2

Figure 3

$$SOH_n = \frac{Rnormalise\_t}{Rnormalise\_batterie\_neuve}$$

Figure 4

```
            ┌──────────────┐
            │   I<Imin     │ ◄────────────── 30
            └──────┬───────┘
                   │
                   ▼
              ╱─────────╲
            ╱  Δt1 < T1  ╲ ◄────────────── 31
            ╲           ╱
              ╲───┬───╱
                  │
                  ▼
              ╱─────────╲
            ╱  Δt2 > T2  ╲ ◄────────────── 32
            ╲           ╱
              ╲───┬───╱
                  │
                  ▼
            ┌──────────────┐
            │  Un ; In ; Rn │ ◄──────────── 40
            └──────────────┘
```

Figure 5

Figure 6

Figure 7

Figure 8

Figure 9

Figure 10

Figure 11

| P | 20% | 50% | 68% | 90% | 95% | 95,50% | 98% | 99% | 99,70% |
|---|---|---|---|---|---|---|---|---|---|
| p | 0,8 | 0,5 | 0,32 | 0,1 | 0,05 | 0,045 | 0,02 | 0,01 | 0,003 |
| v =n-1 | | | | | | | | | |
| 1 | 0,325 | 1,000 | 1,819 | 6,314 | 12,706 | 14,124 | 31,821 | 63,657 | 212,205 |
| 2 | 0,289 | 0,816 | 1,312 | 2,920 | 4,303 | 4,553 | 6,965 | 9,925 | 18,216 |
| 3 | 0,277 | 0,765 | 1,189 | 2,353 | 3,182 | 3,322 | 4,541 | 5,841 | 8,891 |
| 4 | 0,271 | 0,741 | 1,134 | 2,132 | 2,776 | 2,880 | 3,747 | 4,604 | 6,435 |
| 5 | 0,267 | 0,727 | 1,104 | 2,015 | 2,571 | 2,658 | 3,365 | 4,032 | 5,376 |
| 6 | 0,265 | 0,718 | 1,084 | 1,943 | 2,447 | 2,525 | 3,143 | 3,707 | 4,800 |
| 7 | 0,263 | 0,711 | 1,070 | 1,895 | 2,365 | 2,436 | 2,998 | 3,499 | 4,442 |
| 8 | 0,262 | 0,706 | 1,060 | 1,860 | 2,306 | 2,373 | 2,896 | 3,355 | 4,199 |
| 9 | 0,261 | 0,703 | 1,053 | 1,833 | 2,262 | 2,327 | 2,821 | 3,250 | 4,024 |
| 10 | 0,260 | 0,700 | 1,046 | 1,812 | 2,228 | 2,290 | 2,764 | 3,169 | 3,892 |
| 11 | 0,260 | 0,697 | 1,041 | 1,796 | 2,201 | 2,261 | 2,718 | 3,106 | 3,789 |
| 12 | 0,259 | 0,695 | 1,037 | 1,782 | 2,179 | 2,237 | 2,681 | 3,055 | 3,706 |
| 13 | 0,259 | 0,694 | 1,034 | 1,771 | 2,160 | 2,218 | 2,650 | 3,012 | 3,639 |
| 14 | 0,258 | 0,692 | 1,031 | 1,761 | 2,145 | 2,201 | 2,624 | 2,977 | 3,583 |
| 15 | 0,258 | 0,691 | 1,029 | 1,753 | 2,131 | 2,187 | 2,602 | 2,947 | 3,535 |
| 16 | 0,258 | 0,690 | 1,026 | 1,746 | 2,120 | 2,175 | 2,583 | 2,921 | 3,494 |
| 17 | 0,257 | 0,689 | 1,024 | 1,740 | 2,110 | 2,164 | 2,567 | 2,898 | 3,459 |
| 18 | 0,257 | 0,688 | 1,023 | 1,734 | 2,101 | 2,154 | 2,552 | 2,878 | 3,428 |
| 19 | 0,257 | 0,688 | 1,021 | 1,729 | 2,093 | 2,146 | 2,539 | 2,861 | 3,401 |
| 20 | 0,257 | 0,687 | 1,020 | 1,725 | 2,086 | 2,139 | 2,528 | 2,845 | 3,376 |
| 30 | 0,256 | 0,683 | 1,011 | 1,697 | 2,042 | 2,092 | 2,457 | 2,750 | 3,230 |
| 40 | 0,255 | 0,681 | 1,007 | 1,684 | 2,021 | 2,070 | 2,423 | 2,704 | 3,160 |
| 60 | 0,254 | 0,679 | 1,003 | 1,671 | 2,000 | 2,047 | 2,390 | 2,660 | 3,094 |
| 100 | 0,254 | 0,677 | 0,999 | 1,660 | 1,984 | 2,030 | 2,364 | 2,626 | 3,042 |
| 150 | 0,254 | 0,676 | 0,998 | 1,655 | 1,976 | 2,022 | 2,351 | 2,609 | 3,017 |
| ∞ | 0,253 | 0,674 | 0,994 | 1,645 | 1,960 | 2,005 | 2,326 | 2,576 | 2,968 |

Figure 12

Figure 13

210 — Mesure U, I à un niveau 1

220 — Détermination de la SOC par étude statistique au niveau 1 — non

oui

215 — Mesure U, I à un niveau 2

230 — Niveau 2 différent du niveau 1 (seuil minimal à dépasser) — non

oui

240 — Détermination de la SOC par étude statistique au niveau 2 — non

oui

250 — Etude statistique Calcul de la capacité et de l'incertitude

260 — If (précision <= précision désirée)

non — oui

Mesure non valide: pas de capacité en sortie

Mesure valide: valeur de la capacité en sortie — 270

265

Capacité normalisée — 280

290 — $SOHc = \dfrac{Cnormalisée}{Cnormalisée\_batterie\_neuve}$

300 — SOH batterie

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2920884 A
- WO 2007004817 A
- US 20090140744 A
- US 20090085517 A
- EP 1632782 A
- US 5991707 A